(19) Europäisches Patentamt
European Patent Office
Office européen des brevets

(11) **EP 4 549 964 A1**

(12) **EUROPEAN PATENT APPLICATION**

(43) Date of publication:
**07.05.2025 Bulletin 2025/19**

(21) Application number: **23207819.6**

(22) Date of filing: **05.11.2023**

(51) International Patent Classification (IPC):
**G01R 31/28** (2006.01)     **G01R 31/26** (2020.01)
**H01L 21/66** (2006.01)

(52) Cooperative Patent Classification (CPC):
**G01R 31/2858;** G01R 31/2623; G01R 31/2626;
H01L 22/14

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicants:
• **Imec VZW**
**3001 Leuven (BE)**
• **Katholieke Universiteit Leuven**
**KU Leuven Research & Development**
**3000 Leuven (BE)**

(72) Inventors:
• **DEGRAEVE, Robin**
**9840 De Pinte (BE)**
• **VARANASI, Anirudh**
**3000 Leuven (BE)**
• **ROUSSEL, Philippe**
**3210 Lubbeek (BE)**

(74) Representative: **Patent Department IMEC**
**IMEC vzw**
**Patent Department**
**Kapeldreef 75**
**3001 Leuven (BE)**

(54) **MACHINE LEARNING-BASED TOOL TO CHARACTERIZE INDIVIDUAL OXIDE DEFECTS**

(57)     A method for characterizing oxide defects in semiconductor devices is described. Based on time-resolved SILC data, a total number of active oxide defects and each defect's characteristics can be determined for a deeply-scaled FET device. The discrete changes in leakage current correspond to switching of a single defect. A Bayesian-inspired algorithm is utilized to extract distinct current levels and experimental data is quantized into these extracted current levels by filtering noise. The evolution of current levels corresponds to a Markov chain. The defect currents are extracted by clustering transition probabilities and absolute differences in current levels using an affinity propagation algorithm. A maximum likelihood estimator is developed to extract a base leakage current. Lastly, defect currents are used to reconstruct the experimental data and its deconvolution into activity of individual defects provides the respective time constants.

Figure 1

EP 4 549 964 A1

**Description**

**TECHNICAL FIELD OF THE INVENTION**

The present description relates to the field of semiconductor device characterization. More specifically, it relates to ways to identify and characterize individual oxide defects in deeply-scaled complementary metal-oxide-semiconductor (CMOS) devices.

**BACKGROUND OF THE INVENTION**

It has been widely recognized that degradation mechanisms involving field-effect transistor (FET) gate current, such as stress-induced leakage current (SILC) and time-dependent dielectric breakdown (TDDB), are predominantly influenced by a small number of material defects. These defects can cause significant leakage currents and potential bridge the gate oxide ('percolation'). Moreover, the continuous downscaling of VLSI devices led to the reduction of lateral dimensions toward the 10 nm range and gate oxide to a thickness of ~1 nm. In such cases, there is a sizable impact on the drive current as well as on the gate leakage current resulting from a few stochastically-behaving defects in the FET gate oxide. This manifests as time-dependent variability and Random Telegraph Noise (RTN). As described herein, in large devices, each defect (random) behavior collectively averages out which results in a well-defined lifetime. However, in deeply-scaled devices, only a small number of defects exist and their stochastic nature, grounded in Poisson statistics, results in large variations in device behavior.

Therefore, there exists a need to understand device degradation at the level of individual defects in this new paradigm of reliability physics. Performing reliability research is becoming more and more complicated using current statistical methods and simulations due to nanometer and smaller dimension scaling. This disclosure addresses the need for a defect analysis methodology to enable state-of-the-art reliability research.

**SUMMARY OF THE INVENTION**

The present disclosure describes tools and methods to detect and characterize the properties of individual oxide defects through their charge/discharge behavior in deeply-scaled semiconductor devices. The tools and related methods operate in a fully automated way to analyze the convoluted RTN characteristics of these defects. Whereas conventional methods can only provide characteristics when one or two defects are causing RTN, the presently disclosed method can handle more complex signals resulting from multiple defects.

In an inventive aspect, a method is provided. The method includes receiving measurement data. The measurement data is indicative of a random telegraph noise (RTN) signal. The method additionally includes extracting from the measurement data, using a Bayesian machine learning algorithm, a set of extracted discrete levels. The method also includes quantizing the measurement data by assigning each data point of the measurement data to a corresponding extracted discrete level. The method yet further includes determining, based on the quantized measurement data, a number of possible defect configurations. The method includes applying a Markov Chain model to the time evolution of the extracted discrete levels to provide a state transition matrix. The state transition matrix includes, for each extracted discrete level, a transition probability of transitioning to a different extracted discrete level. The method yet further includes determining, for each extracted discrete level, a respective transition probability. The method also includes forming, based on a magnitude difference between respective discrete levels and the transition probabilities, a magnitude/transition probability space. The method additionally includes applying a clustering model to the magnitude/transition probability space to reduce a total number of plausible level combinations to a filtered set of plausible level combinations. The method includes determining, using a maximum likelihood estimator, a base leakage value. The method also includes determining, by mapping the extracted discrete levels to a linear superposition of each level of a set selected from the filtered set of plausible level combinations, a best fit data reconstruction of the measurement data and corresponding predicted levels.

Particular aspects of the embodiments are set out in the accompanying independent and dependent claims. Features from the dependent claims may be combined with features of the independent claims and with features of other dependent claims as appropriate and not merely as explicitly set out in the claims.

These and other aspects will be apparent from and elucidated with reference to the embodiment(s) described hereinafter.

**BRIEF DESCRIPTION OF THE DRAWINGS**

The above, as well as additional, features will be better understood through the following illustrative and non-limiting detailed description of example embodiments, with reference to the appended drawings.

FIG. 1 illustrates a method, in accordance with an example embodiment.

FIG. 2 illustrates a semiconductor device, in accordance with an example embodiment.

FIG. 3 illustrates electrical measurement data for two differently sized semiconductor devices, in accordance with example embodiments.

FIG. 4 illustrates electrical measurement data for a semiconductor device, in accordance with an example embodiment.

FIG. 5 illustrates a portion of the steps of the method of FIG. 1, in accordance with an example embodiment.

FIG. 6 illustrates a graph of absolute current magnitude differences between adjacent current levels from the measurement data, in accordance with an example embodiment.

FIG. 7 illustrates a portion of the Bayesian learning loop, in accordance with an example embodiment.

FIG. 8 illustrates finding an optimal noise level, in accordance with an example embodiment.

FIG. 9 illustrates a probability density versus gate current graph, in accordance with an example embodiment.

FIG. 10 illustrates a noise level versus current level graph, in accordance with an example embodiment.

FIG. 11 illustrates a best fit data reconstruction graph, in accordance with an example embodiment.

FIG. 12 illustrates a state transition matrix, in accordance with an example embodiment.

FIG. 13 illustrates a transition probability versus change in current level, in accordance with an example embodiment.

FIG. 14 illustrates the top six transition probabilities versus change in current level with error bars, in accordance with an example embodiment.

FIG. 15 illustrates the top six transition probabilities versus change in current level with normalized error bars, in accordance with an example embodiment.

FIG. 16 illustrates the top six transition probabilities versus change in current level, in accordance with an example embodiment.

FIG. 17 illustrates the top six transition probabilities versus change in current level, in accordance with an example embodiment.

FIG. 18 illustrates the top six transition probabilities after application of a clustering model, in accordance with an example embodiment.

FIG. 19 illustrates a distribution of Bayesian-based levels and probability density function for individual discrete levels, in accordance with an example embodiment.

FIG. 20 illustrates a distribution of Bayesian-based levels and optimal current configurations, in accordance with an example embodiment.

FIG. 21 illustrates an optimal solution and corresponding data reconstruction, in accordance with an example embodiment.

FIG. 22 illustrates a deconvolution after finding an optimal solution, in accordance with an example embodiment.

Any reference signs in the claims shall not be construed as limiting the scope.

In the different drawings, the same reference signs refer to the same or analogous elements.

All the figures are schematic, not necessarily to scale, and generally only show parts which are necessary to elucidate example embodiments, wherein other parts may be omitted or merely suggested.

## DETAILED DESCRIPTION OF THE INVENTION

Example embodiments will now be described more fully hereinafter with reference to the accompanying drawings. That which is encompassed by the claims may, however, be embodied in many different forms and should not be construed as limited to the embodiments set forth herein; rather, these embodiments are provided by way of example. Furthermore, like numbers refer to the same or similar elements or components throughout.

The drawings described are only schematic and are non-limiting. In the drawings, the size of some of the elements may be exaggerated and not drawn on scale for illustrative purposes. The dimensions and the relative dimensions do not correspond to actual reductions to practice of the embodiments.

Moreover, the terms top, under and the like in the description and the claims are used for descriptive purposes and not necessarily for describing relative positions. It is to be understood that the terms so used are interchangeable under appropriate circumstances and that the embodiments described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present embodiments, the only relevant components of the device are A and B.

Reference throughout this specification to "one embodiment" or "an embodiment" means that a particular feature, structure or characteristic described in connection with the embodiment is included in at least one embodiment. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments, various features are sometimes grouped together in a single embodiment, figure, or description thereof for the purpose of streamlining the disclosure and aiding in the understanding of one or more of the various aspects. This method of disclosure, however, is not to be interpreted as reflecting an intention that the claimed embodiments requires more features than are expressly recited in each claim. Rather, as the following claims reflect, aspects lie in less than all features of a single foregoing disclosed embodiment. Thus, the claims following the detailed description are hereby expressly incorporated into this detailed description, with each claim standing on its own as a separate embodiment.

Furthermore, while some embodiments described herein include some but not other features included in other embodiments, combinations of features of different embodiments are meant to be within the scope, and form different embodiments, as would be understood by those in the art. For example, in the following claims, any of the claimed embodiments can be used in any combination.

In the description provided herein, numerous specific details are set forth. However, it is understood that embodiments may be practiced without these specific details. In other instances, well-known methods, structures and techniques have not been shown in detail in order not to obscure an understanding of this description.

## I. Overview

The present disclosure describes a physics-informed machine learning (PIML) methodology developed to detect and model the behavior of individual defects in a thin gate oxide of a deeply-scaled CMOS device.

The presence of a small number of individual defects in oxide results in Random Telegraph Noise (RTN) that can be measured as a function of time by monitoring the gate leakage current. The creation of a new oxide defect is reflected by an abrupt increase in the time-resolved gate leakage current measured at a constant stress voltage. Such creation of a single defect is known as a 'discrete' stress-induced leakage current (SILC) event that can be observed due to the presence of only a handful of oxide defects.

As an example, devices of interest could include a scaled High-k metal gate (HKMG) MOSFET formed based on a technology node such as 28 nm. In such scenarios, the gate oxide could be a hafnium oxide layer with a thickness of 1.8 nm.

In some embodiments, SILC may be measured as a function of time with a constant gate voltage bias of 1.2 V. It will be understood that other gate voltage bias values are possible and contemplated. In various examples, the gate voltage bias could reflect a standard device operating condition, as opposed to an accelerated operating condition. In other words, the device under test could may have a voltage bias in accordance with a manufacturer-recommended gate bias as opposed to a higher voltage as may be applied in an accelerated testing scenario.

Put another way, the measurement data described herein may be obtained under normal operating conditions of the semiconductor device. The normal operating conditions of the semiconductor device could include, among other elements, a standard operating bias voltage as recommended by a manufacturer of the semiconductor device. In various examples, the measurement data described herein is *not* obtained under accelerated operating conditions of the semiconductor device. For example, accelerated operating conditions could include an elevated bias voltage.

In an example embodiment, data may be collected at a sampling rate of 50 Hz (20 ms period) for $10^4$ seconds. It will be understood that other sampling rates and time periods could be utilized. The experimental data has measurement noise and intrinsic fluctuations on top of discrete changes between current levels corresponding to charge/discharge of individual defects.

Analysing the experimental data, the total number of current levels observed are extracted where each current level is represented by a Gaussian distribution with two parameters, mean and sigma. A Bayesian-inspired algorithm is developed to extract the distinct current levels that clearly explain the observed experimental data.

Subsequently, measurement noise is filtered by quantizing the data where each data point is assigned to their corresponding extracted current level based on the distribution parameters. Since defects in thin gate oxide are independent and defect physics does not possess internal memory, evolution of extracted current levels corresponds to a Markov chain. An algorithm is utilized to extract the transition probabilities from the as-observed switching between extracted current levels.

Each extracted current level corresponds to a defect configuration. In an N-defect system, a total of $2^N$ configurations are possible i.e., each defect is in a charged state or a discharged state corresponding to either high or low conduction in the leakage path corresponding to that defect. The capture (charge) and emission (discharge) times of oxide defects can range from few microseconds to days. When only a small number of defects are present, the probability of two defects switching simultaneously is highly improbable. This mathematical constraint simplifies the transition observed between two current levels as switching of a single defect. Furthermore, the absolute difference of magnitude between two current levels corresponds to a defect current, i.e. the leakage current through a path mediated by the defect. The information available regarding the transition probabilities and current levels' differences is utilized to extract the individual defects (defect current) observed in the data. A machine learning algorithm such as Affinity Propagation could be used for this purpose.

In the next step, a maximum likelihood estimator is used to determine the base leakage current, i.e. the remaining leakage current when all defect-mediated leakage paths are not conducting. The base leakage current may include a state where all defects are not conducting. It should be noted that in some cases, the charged state corresponds to a conducting/active state and the discharged/inactive state corresponds to a non-conducting state. However, in other cases, the discharged state could correspond to the conducting state and vice versa.

Finally, the individual defect currents are analysed for accurate reconstruction of the experimental data. The reconstructed data is deconvoluted into conducting / non-conducting cycles of individual extracted current levels / defects, which in turn provides the time constants associated to each defect.

The systems and methods described in the present disclosure offer several benefits over conventional solutions. As an example, methods herein may be utilized to detect the creation and charge/discharge of individual defects in a gate oxide of FET-type devices. Successful detection of individual defects in a gate oxide enables a pathway to multiple unprecedented applications:

a monitoring tool for oxide degradation (at low voltage);
prediction of gate oxide breakdown for an individual transistor;
mapping and characterizing each defect signature to a type of oxide defect in a new material - especially in multi-layer materials, this can provide unprecedented insights to the material structure and degradation; and
validating traditional device degradation models (developed at accelerated conditions) by obtaining stress-induced leakage current (SILC) data at normal device operating conditions.

## II. Example Methods

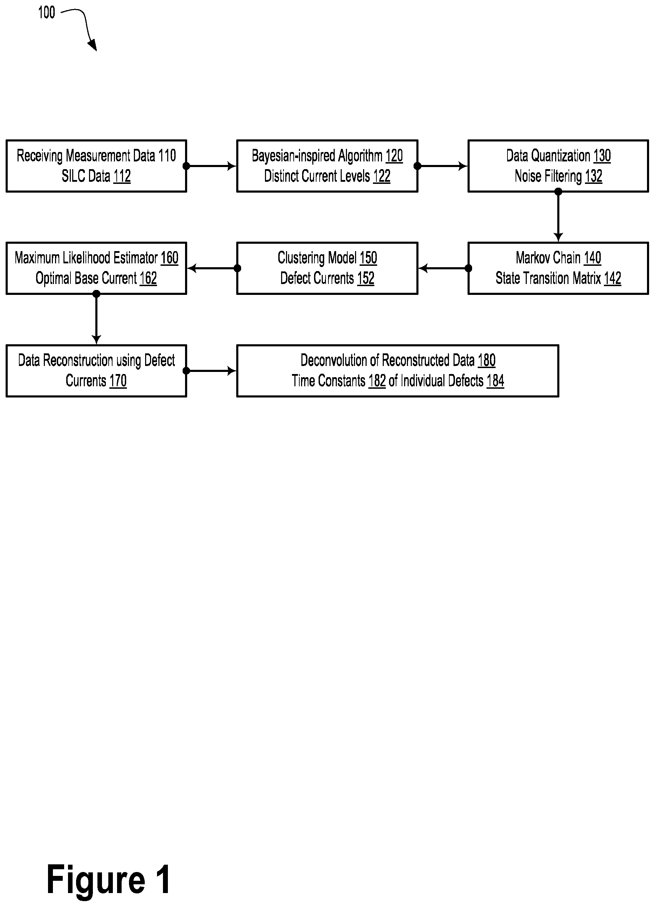

FIG. 1 illustrates a method 100, in accordance with an example embodiment. By way of illustrative examples, reference will be made to other figures to describe the steps or blocks of method 100. Although example embodiments may be described as carrying out certain blocks or steps in a particular order, it will be understood that such blocks or steps may be carried out in a different order. Additionally, steps or blocks could be repeated and/or omitted within the scope of this disclosure.

Method 100 may include three modules: (i) First, the measured $I_{g,leak}$ is described as a set of discrete constant observed current levels using a Bayesian-inspired algorithm. (ii) Subsequently, these discrete current levels are mapped to possible defect sets. Each set generates a list of linear superpositions of individual leakage paths referred to as 'configurations'. The mapping is achieved using a Markov process modeling combined with the affinity propagation (AP) clustering algorithm. (iii) Finally, the optimal solution, i.e., the optimal set of defects that can explain the observed data, is selected after data reconstruction through the definition of a cost function. These modules are now described in detail.

Method 100 includes receiving measurement data 110. In example embodiments, the measurement data is indicative of a random telegraph noise (RTN) signal. RTN is a type of electronic noise that occurs in semiconductors and ultra-thin gate oxide films. Specifically, the RTN signal could be due to a presence of defects in a gate oxide of a semiconductor device. It is also called burst noise, popcorn noise, impulse noise, bi-stable noise, or random telegraph signal (RTS) noise.

RTN is typically caused by the trapping and detrapping of charge carriers at defects in the gate dielectric of a semiconductor device. These defects can be caused by manufacturing processes, such as heavy ion implantation, or by unintentional side-effects such as surface contamination or are intrinsically present due to the amorphous structure of the material. RTN manifests itself as discrete jumps in the current or voltage of a semiconductor device. The jumps are random in time and amplitude, but they can be characterized by two characteristic time constants: one for the trapping of charge carriers and one for the detrapping of charge carriers.

RTN can be a problem for semiconductor devices because it can cause errors in analog circuits and reduce the reliability of digital circuits. RTN is particularly important in advanced semiconductor devices, such as those used in smartphones and other mobile devices, where the gate dielectric is very thin.

In some embodiments, the measurement data 110 could include information indicative of a stress-induced leakage current (SILC) measurement. As such, the measurement data could include SILC data 112. In some scenarios, receiving measurement data could include receiving electrical signals from a semiconductor device. As an example, the semiconductor device could include a high-k gate dielectric layer of a metal-oxide-semiconductor field-effect transistor (MOSFET). In such scenarios, at least a portion of the RTN signal is indicative of a time-dependent dielectric breakdown (TDDB) of the gate dielectric layer.

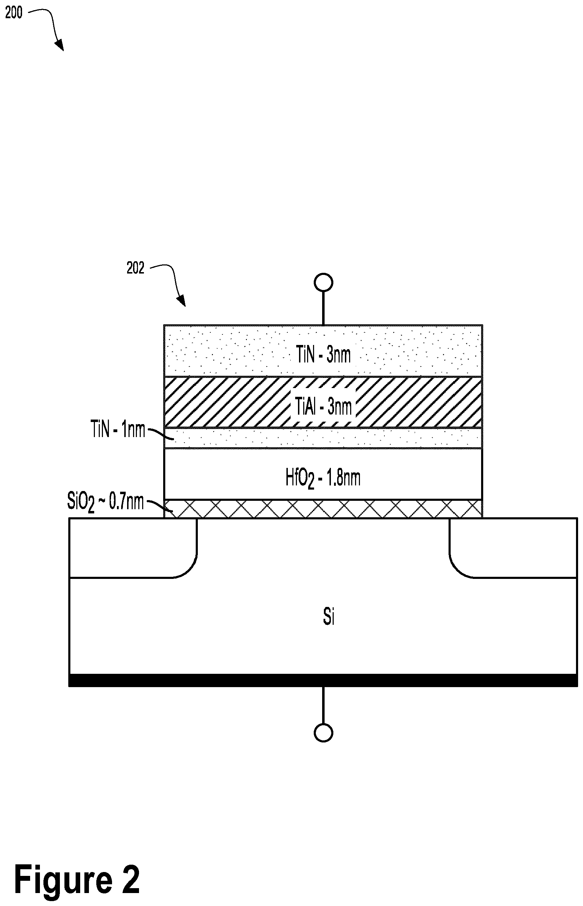

FIG. 2 illustrates a semiconductor device 200, in accordance with an example embodiment. In an example embodiment, the semiconductor device 200 could be a MOSFET with a gate dielectric stack 202. The gate dielectric stack 202 could be a high-k gate stack including, among other possibilities, a $SiO_2$ layer (~0.7 nm thick), a $HfO_2$ layer (1.8 nm thick), a TiN layer (1 nm thick), a TiAl layer (3 nm thick), and a TiN layer (3 nm thick). In some examples, the gate dielectric stack 202 could have an area of $300 \times 300$ nm². Additionally or alternatively, the gate dielectric stack 202 could be similar or identical to that of the 28 nm technology node.

It will be understood that other dielectric stacks and discrete dielectric layers are possible and contemplated.

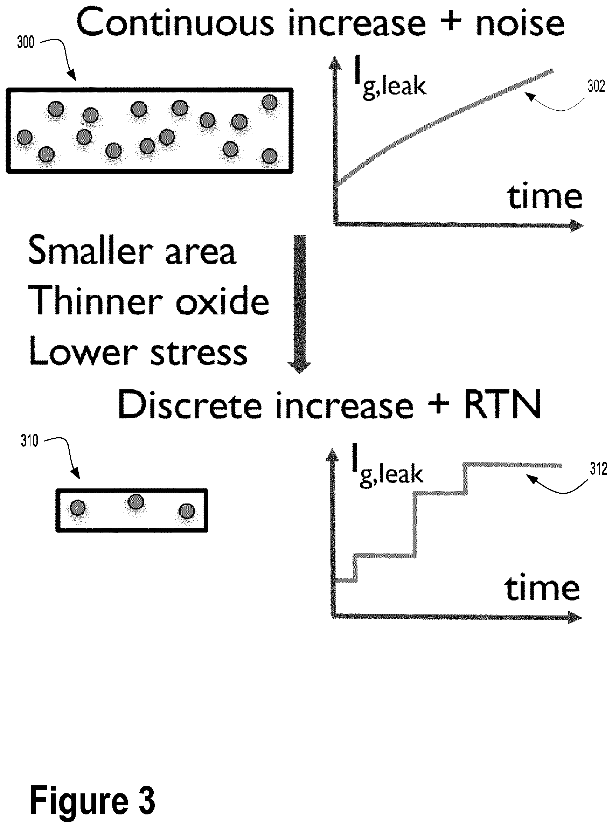

FIG. 3 illustrates electrical measurement data 302 for a relatively large area gate dielectric 300 (e.g., $1 \times 1$ μm²) and electrical measurement data 312 for a relatively small area gate dielectric 310 (e.g., $0.1 \times 0.1$ μm²), in accordance with example embodiments. As can be observed from electrical measurement data 302, when a static gate bias voltage is applied, the gate leakage current increases relatively smoothly over time. In such a scenario, the gate oxide could include on the order of 800 traps.

As illustrated in electrical measurement data 312, the gate leakage current changes abruptly in a step-wise fashion over time. This behavior indicates a RTN signal. In such a scenario, the gate oxide could include on the order of 8 traps.

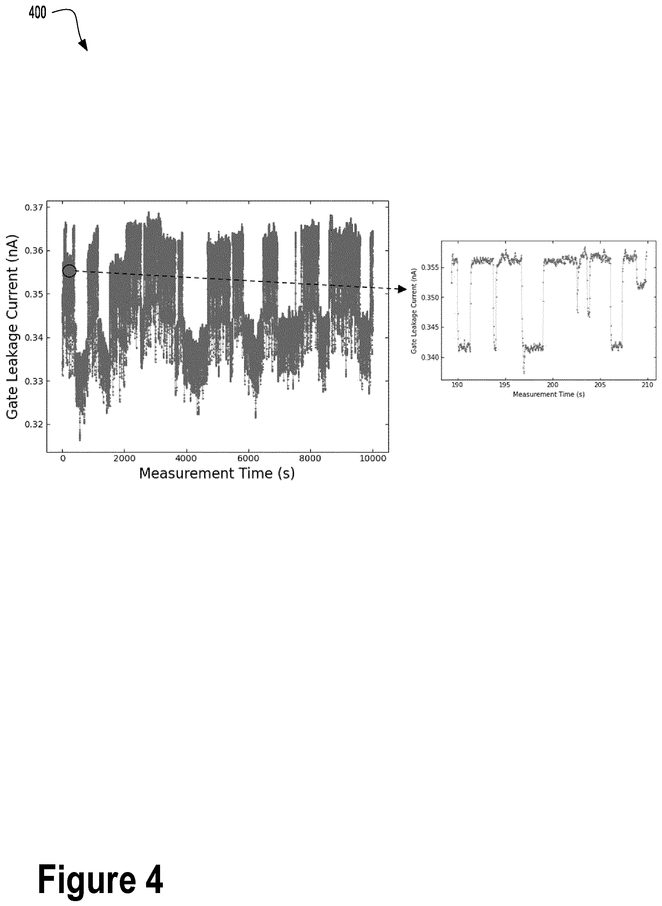

FIG. 4 illustrates electrical measurement data 400 for a semiconductor device, in accordance with an example embodiment. The measurement data 400 shows the gate leakage current over time and was obtained with a $SiO_2/HfO_2$ gate dielectric (0.7/1.8 nm thickness) under a gate voltage of 1.2 volts. As shown, the measurement data 400 indicates multiple abrupt jumps in leakage current. These abrupt changes typically indicate creation and/or destruction of a single trap conduction path, which may be considered a discrete SILC event.

Method 100 includes using a Bayesian machine learning algorithm 120 to extract a set of extracted discrete levels (e.g., distinct current levels 122) from the measurement data. It will be understood that the set of extracted discrete levels could include a set of current values or a set of voltage values.

Method 100 also includes performing a data quantization 130 by assigning each data point of the measurement data to a corresponding extracted discrete level.

Method 100 also includes determining, based on the quantized measurement data, a number of possible defect configurations.

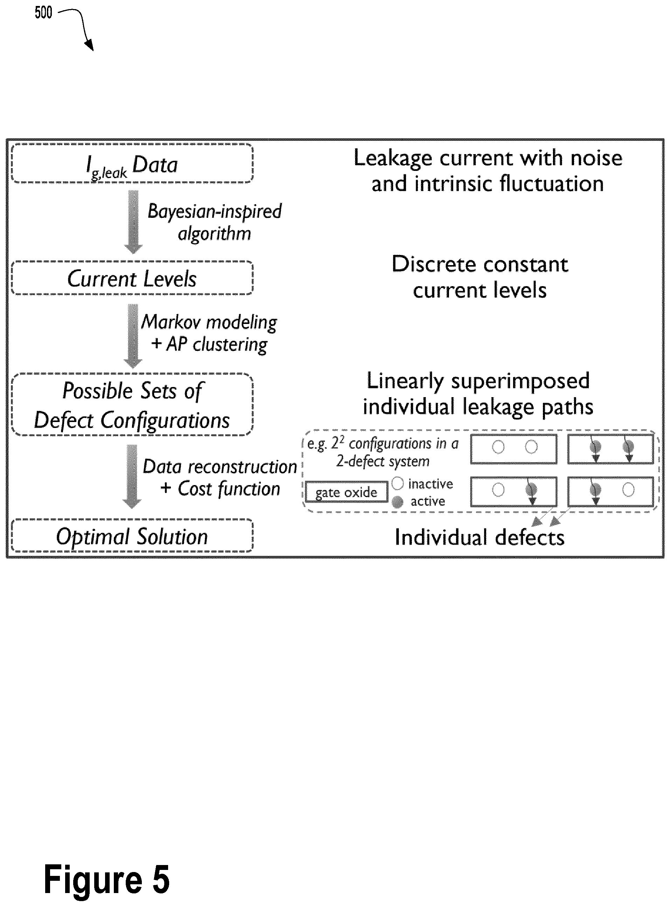

FIG. 5 illustrates a portion 500 of the steps of the method 100 of FIG. 1, in accordance with an example embodiment. For example, upon receiving measurement data 110, the SILC data 112 could be quantized into distinct current levels 122 obtained using the Bayesian-inspired algorithm 120. Furthermore, based on N defects, $2^N$ defect configurations are possible due to independent charge/discharge trap events.

As an example, a number of oxide defects turned on over time period t $[0, 10^4]$ seconds can be estimated from assuming a defect density = ~$[10^{14}, 5 \times 10^{16}]$ cm⁻³ for a device area = $300 \times 300$ nm² and oxide thickness = 1.8 nm. In such scenarios, the # defects per device = $D_{ox} \times A \times t_{ox}$ = ~$[0.02, 8.1]$. It will be understood that other ranges for the # of defects per device may vary based on, for example, process variables and device variations, among other possibilities.

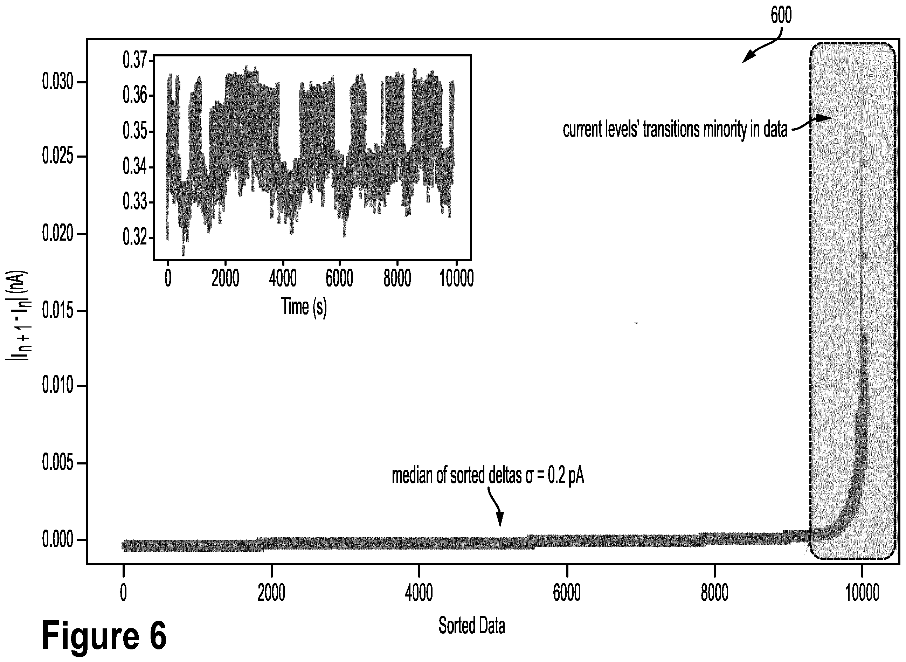

FIG. 6 illustrates a graph 600 of current magnitude differences (e.g., current deltas) between adjacent current levels from the measurement data, in accordance with an example embodiment. Based on this information, a median of sorted current deltas could be about $\sigma = 0.2$ pA. It will be understood that other measurement data could have other median values. In various examples, extracting the current deltas in this way serves as an initial setting for the Bayesian algorithm. In such scenarios, determining the median of sorted current deltas could include initially determining an optimal noise level based on a median 2x2 range-based standard deviation estimator of level transitions in the measurement data.

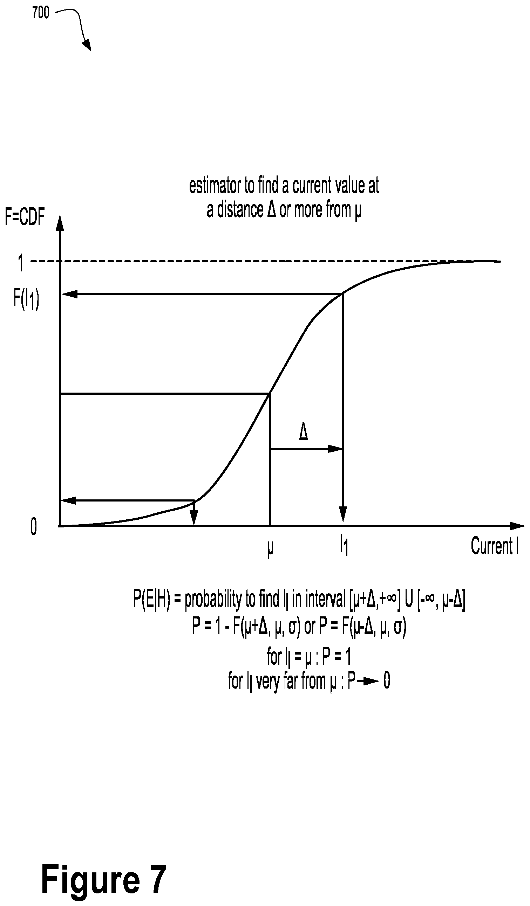

FIG. 7 illustrates a portion 700 of the Bayesian learning loop, in accordance with an example embodiment. Bayes' theorem assigns a degree of belief to a hypothesis and rationally updates that probability based on new evidence. Mathematically, this can be defined as the likelihood of event E occurring given that a hypothesis H is true. Put another way, the Bayesian learning loop described herein is a learning algorithm that explains some given data based on a prior hypothesis and then adapts the hypothesis based on new data.

In various example embodiments, Hypothesis H could include that one current level exists with Gaussian noise and the Event E could include a measured data point (e.g., a gate leakage current value).

$$P(H|E) = \frac{P(E|H).P(H)}{P(E)},$$

where P(H|E) = probability that one current level exists given a data point;
P(H) = prior probability;
P(E|H) = likelihood that a data point belongs to this current level;

P(E) = probability to find that data point = P(H).P(E|H)+P(-H).P(E|-H);

Under such a model, a probability density function of each current level could be represented by a mean, $\mu$ and a standard deviation, $\sigma$. In such scenarios, $\mu$ can be initialized as the measured data point and $\sigma$ can be estimated by a median moving range, such as (median$|I_{i+1}-I_i|$), as illustrated in Figure 6.

By iteratively applying the Bayesian learning loop, the hypothesis may be adapted to include a plurality of Gaussian peaks along the PDF versus current axis.

In the Bayesian learning loop, the likelihood of one current level existing with Gaussian noise is initialized as P(H) = 0.5. As an example, the current level is set at $\mu = I_0 = 0.33$ nA and $\sigma_{initial} = 0.2$ pA. In such a scenario, $\mu$ and $\sigma$ provide the curve illustrated in Figure 7. Subsequently for each discrete level (e.g., i = 1, 2, 3, ...), the loop includes calculating the likelihood P(E|H) to find $I_i$ given hypothesis H.

Next, the posterior likelihood is calculated:

$$P(H|E) = \frac{P(E|H).P(H)}{P(E)}$$

If inadequate based on a predetermined threshold, H is updated, P(H) = 0.5, $\mu = I_i$ and $\sigma = \sigma_{initial}$.

If adequate, $\mu = \frac{1}{N}\sum_{n=1}^{N} I_n$ and $\sigma = \sqrt{\frac{\sum_{n=1}^{N}(I_n-\mu)^2}{N}}$ . $\sigma$ is only updated if a statistically meaningful amount of data points are assigned to the extracted current level $I_n$.

In such a scenario, the posterior likelihood becomes the new prior likelihood P(H) $\rightarrow$ P(H|E).

As illustrated in Figure 7, P(E|H) = probability to find $I_1$ in interval $[\mu+\Delta,+\infty]$ U $[-\infty, \mu-\Delta]$, where P = 1 - F($\mu+\Delta$, $\mu$, $\sigma$) or P = F($\mu-\Delta$, $\mu$, $\sigma$).

As such, for $I_1 = \mu$ : P = 1 and for $I_1$ very far from $\mu$ : P$\rightarrow$0. Increment i until all current values have been evaluated.

In a second loop portion, for 'L' current levels found in the measured data, set i = 1 and find the current level closest to $I_i$. Next, find the current level closest to $I_{i+1}$. If levels of $I_i$ and $I_{i+1}$ match, assign $I_{i+1}$ to the same level as $I_i$. If the levels of $I_i$ and $I_{i+1}$ do not match, the certainty of the measurement is validated with a continuity equation and $I_{i+1}$ is assigned to a different level compared to that of $I_i$. Then, increment i until all data points of the measured data have been evaluated. The continuity equation provides a continuity condition in which a data point $I_i$ can only be assigned to an extracted current level if at least N consecutively observed data points can be assigned to that extracted level. This ensures that outliers, single point measurement errors, and single point transitions between levels are not erroneously assigned to an extracted current level. Furthermore, the continuity condition improves the separation of adjacent current levels with current level differences.

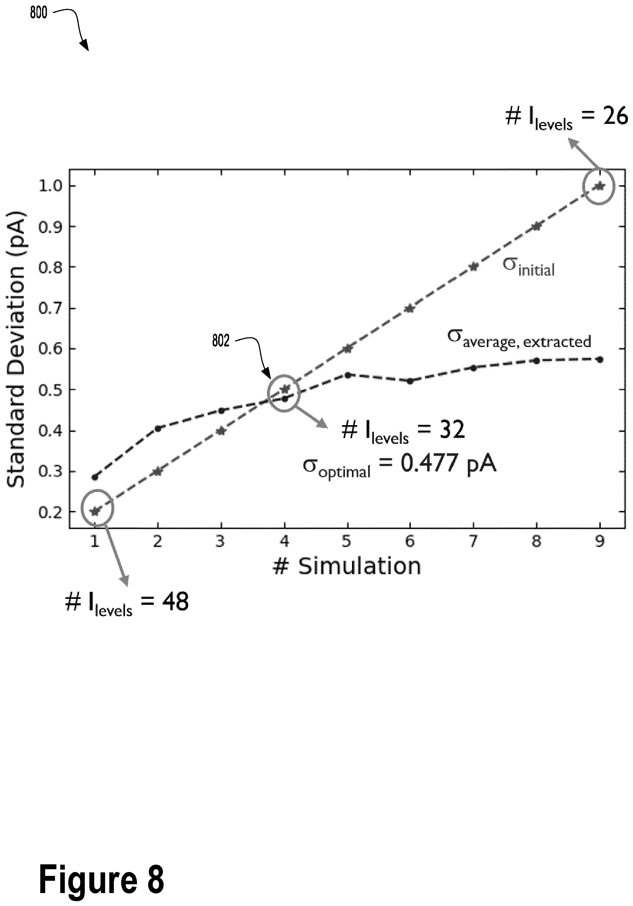

In example embodiments, to accurately estimate the number of current levels, method 100 may include extracting an optimal noise level. As an example, FIG. 8 illustrates a graph 800 for finding an optimal noise level 802. In such scenarios, the Bayesian algorithm 120 could be run several times with different initial noise levels ($\sigma_{initial}$) to find an optimal noise level 802. As an example, the Bayesian loop could be calculated within the range $\sigma_{initial} = [0.2$ pA, 1.0 pA]. In such scenarios, the optimal noise level 802 could be determined when an estimated $\sigma_{average}$ is approximately equal to the respective starting value for $\sigma_{initial}$. In the illustrated case, the optimal noise level 802 could be determined to be approximately 0.477 pA. In some examples, this noise level could correspond to a number of discrete levels, $N_{levels} = 32$. It will be understood that other values for optimal noise level 802 and $N_{levels}$ are possible and contemplated.

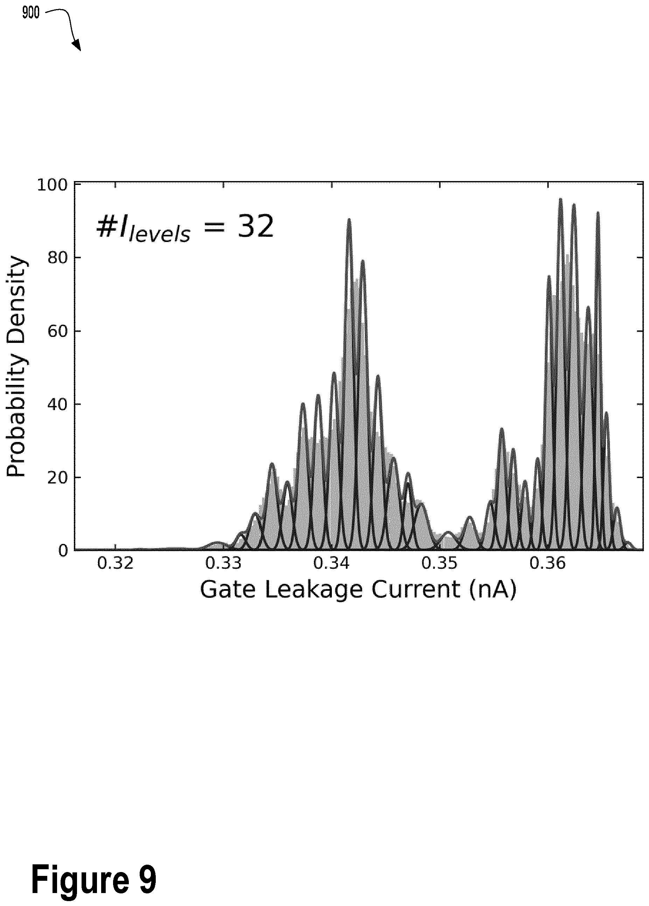

FIG. 9 illustrates a probability density versus gate current graph 900, in accordance with an example embodiment. In this case, the graph 900 corresponds to the $N_{levels} = 32$ scenario described above. In such a case, graph 900 includes a plurality of Gaussian curves corresponding to each of the 32 levels determined using the Bayesian algorithm 120.

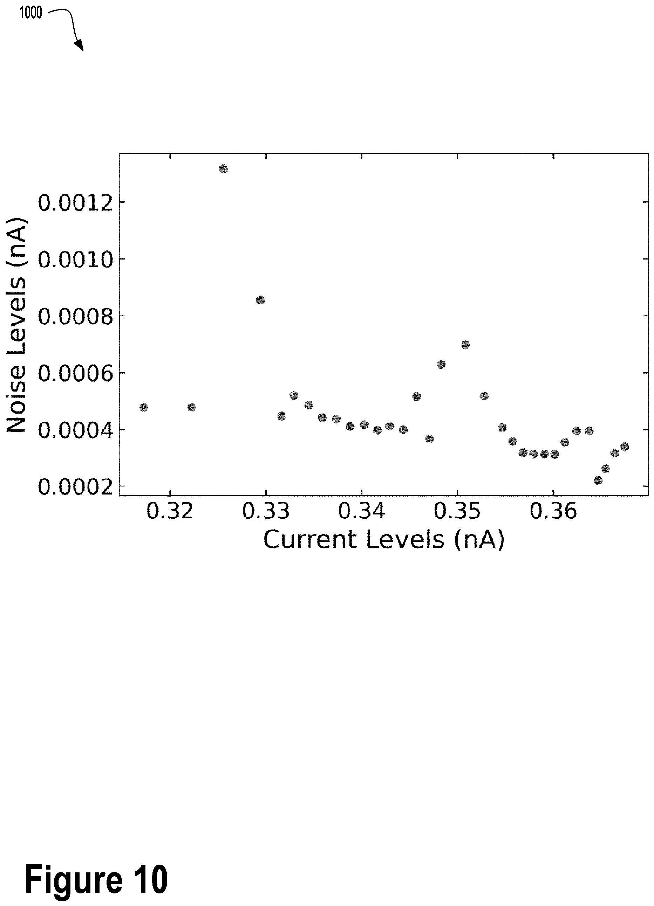

FIG. 10 illustrates a noise level versus current level graph 1000, in accordance with an example embodiment. In graph 1000, each of the data points indicates the noise level of each of the 32 extracted current levels from the Bayesian algorithm 120. As such, the average of the respective data points = $\sigma_{average} = 0.477$ pA - corresponding to optimal noise level 802.

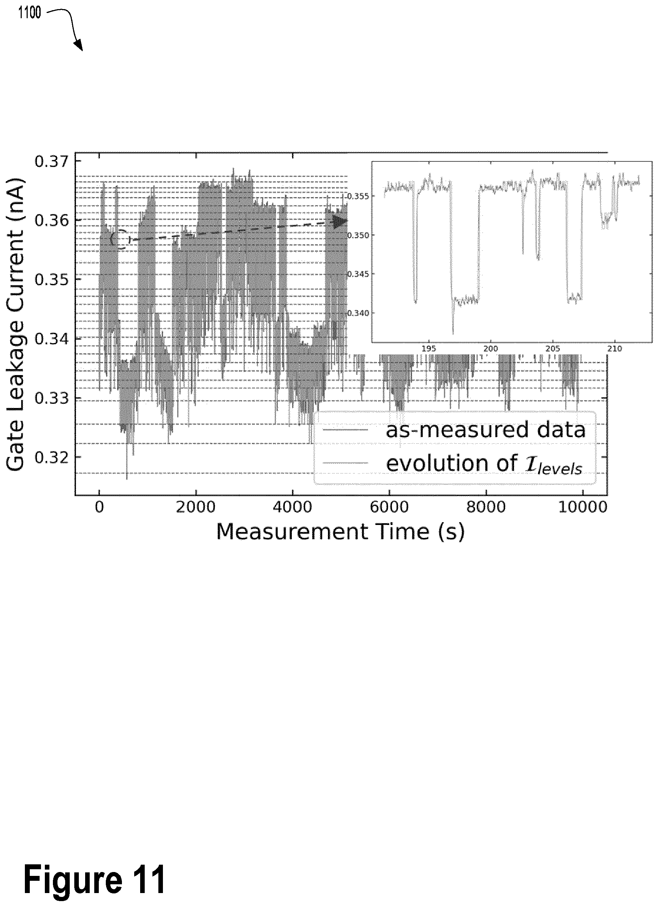

FIG. 11 illustrates a best fit data graph 1100, in accordance with an example embodiment. In such scenarios, the fit curve is provided by the second loop portion of the Bayesian algorithm 120, where each data point is assigned to a discrete current level. In other words, the data points may be quantized into discrete extracted current levels.

In general, a Markov Chain may be used as a mathematical model to describe a system that transitions between different states over time, with the probability of transitioning from one state to another depending only on the current state and not on any past states. In other words, a Markov chain can represent a random walk through a set of states. At each step, a walker moves from one state to another according to a certain probability distribution. The probability distribution depends only on the current state, not on the path that the walker took to get there.

Applied to the present disclosure, the evolution of current levels in the measured data corresponds to a Markov chain. In such a scenario, defect physics does not deal with long-term history - there is no internal memory. Furthermore, defects in thin gate oxides are independent from one another.

As such, method 100 additionally includes applying a Markov Chain model 140 to the extracted discrete levels to provide a state transition matrix 142. In such scenarios, the state transition matrix 142 could include, for each extracted discrete level, a transition probability of transitioning from a given extracted discrete level to a different extracted discrete level.

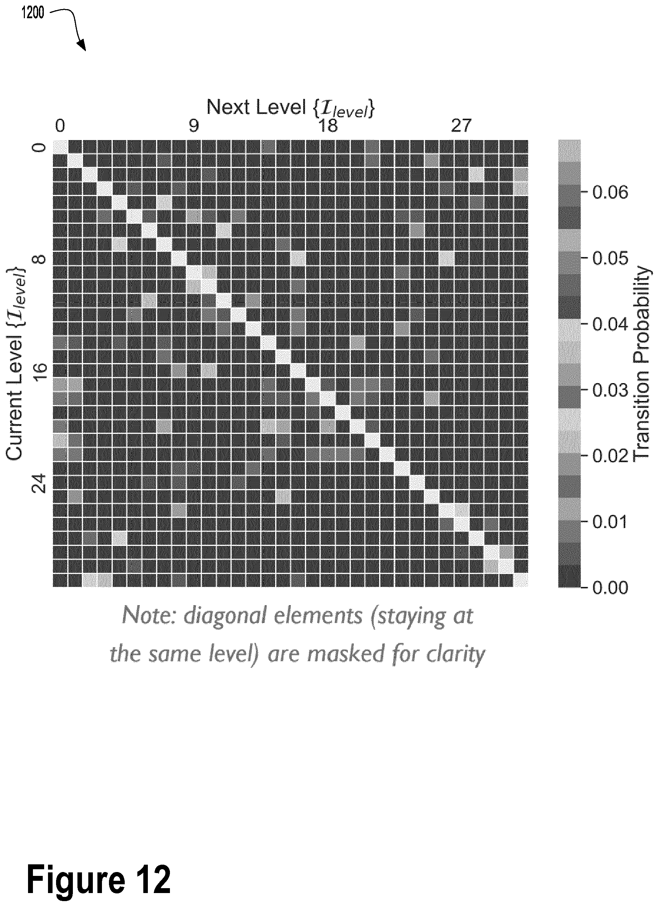

FIG. 12 illustrates a state transition matrix 1200, in accordance with an example embodiment. In some embodiments, the state transition matrix 1200 or state transition matrix 142 can be visualized as an NxN matrix, $A_{ij}$. In such scenarios, $A_{ij}$ can represent the probability to transition from current level $I_i$ to current level $I_j$. The diagonal matrix elements of the state transition matrix 1200 have been left blank for illustration clarity.

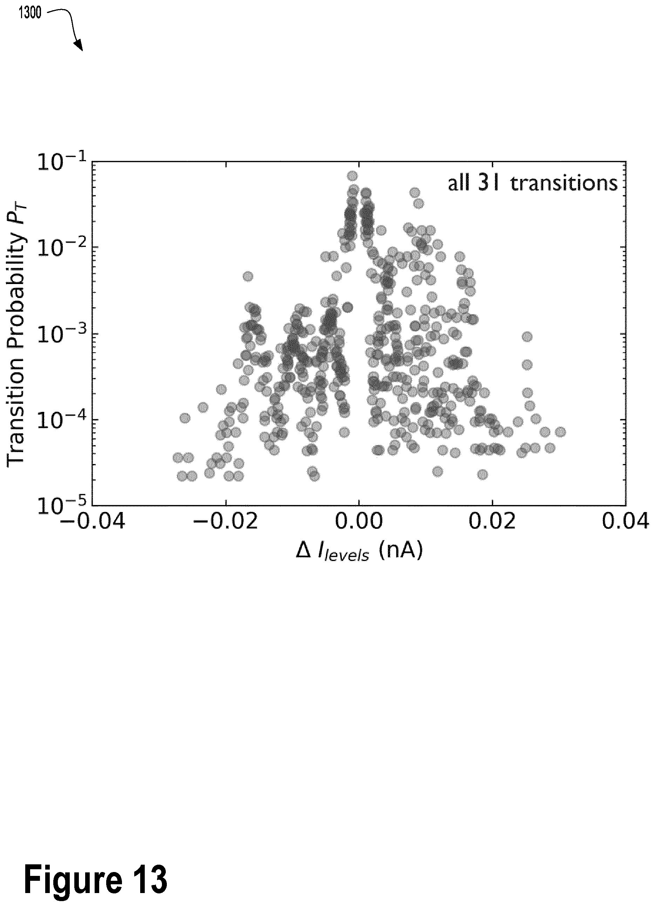

FIG. 13 illustrates a graph 1300 of transition probability versus change in current level, in accordance with an example embodiment. The 31 data points of graph 1300 correspond to the example where N = 32. In such a scenario, the 31 data points represent the probability of a transition from one state to another (y-axis) versus the difference in current level (x-axis).

$\Delta I_{levels}$ can form the abrupt changes in the RTN signal and measured data and may be considered defect currents $\{I_{defects}\}$.

As described herein, the boundary conditions include that simultaneous charge/discharge of defects is highly improbable i.e., a given configuration 'i' can only transition to a maximum of 5 distinct configurations. It will be understood that 5 distinct configurations will be available for a 5 defect system, 6 distinct configurations will be available for a 6 defect system, and so on. Elsewhere herein, a 6 defect system is provided as an example. Accordingly, the corresponding description references the "top 6" transitions probabilities, current levels, etc.

Method 100 also includes forming, based on a magnitude difference between respective discrete levels and the transition probability, a magnitude transition probability space.

Clustering is valid for a 2-variable system only when their average error bars are on same scale. Accordingly, applying the clustering model could include initially normalizing the state transition matrix such that respective error bars for transition probability and level difference are similar.

If the current level deltas are given as $\Delta I_{levels} = I_x - I_y$, then

$$\sigma_{\Delta I} = \sqrt{\sigma_x^2 + \sigma_y^2}$$

the error on $\Delta I_{levels}$ may be written as .

Normalizing the current level deltas may be performed by $\Delta I_{levels,norm} = \Delta I_{levels} / \text{median}(\sigma_{\Delta I})$.

Similarly, normalizing the corresponding error could be given by $\sigma_{\Delta I,norm} = \sigma_{\Delta I} / \text{median}(\sigma_{\Delta I})$.

If transition probability is written as $P_{transition} = \dfrac{\{I_x \to I_y\}}{\sum_{k=1}^{N} \{I_x \to I_k\}}$, then

The error on $P_{transition}$ may be given as $E_{transition} = \dfrac{\sqrt{\{I_x \to I_y\}}}{\sum_{k=1}^{N} \{I_x \to I_k\}}$ (for a Poisson process).

Normalizing the probability of transitions could be performed by Normalized $\log(P_{transition}) = \log(P_{transition}) / \text{median}(\log(E_{transition}))$ and Normalized $\log(E_{transition}) = \log(E_{transition}) / \text{median}(\log(E_{transition}))$,

where $\log(E_{transition}) = \log(P_{transition} + E_{transition}) - \log(P_{transition})$.

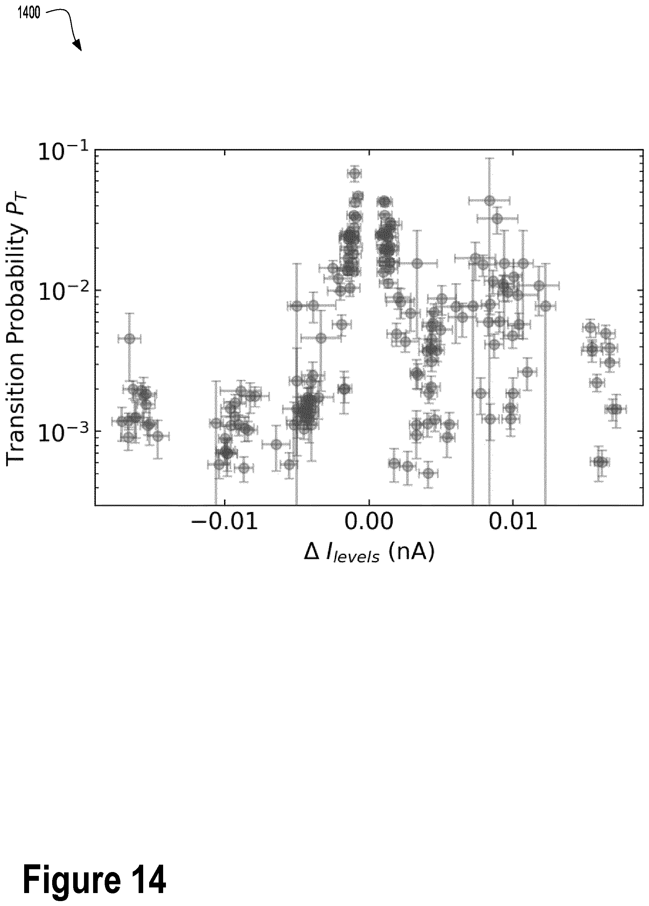

FIG. 14 illustrates a graph 1400 of the top six transition probabilities versus change in current level with error bars (prior to normalization), in accordance with an example embodiment.

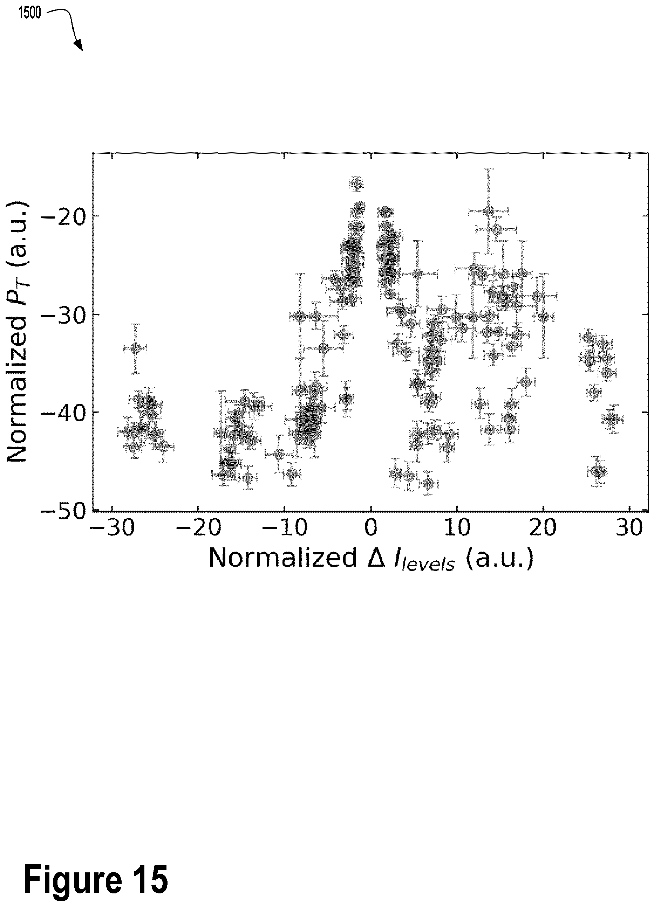

FIG. 15 illustrates a graph 1500 of the top six transition probabilities versus change in current level after normalization, in accordance with an example embodiment.

After normalization, clustering may be performed on the state transition data points. In some embodiments, the clustering model could include an affinity propagation algorithm. Affinity propagation (AP) is an unsupervised machine learning algorithm used to cluster data points into multiple groups based on their similarity. In AP, the number of clusters need not be specified in advance, in contrast to k-means and hierarchical clustering models. AP works by passing messages between data points. Each data point sends messages to all other data points, indicating how well-suited each other is to be an exemplar. An exemplar is a data point that is representative of a cluster. The messages are exchanged iteratively, and the algorithm converges when a stable set of exemplars has been found. The data points that belong to the same cluster are then assigned to the exemplar for that cluster.

As such, method 100 additionally includes applying a clustering model 150 to the magnitude transition probability space to reduce a total number of plausible level combinations to a filtered set of plausible level combinations and defect currents 152.

To determine the most likely configurations, formation clustering may be performed based on different time constants of distinct defects. As an example, method 100 may include determining, for each extracted discrete level, a respective time constant 182.

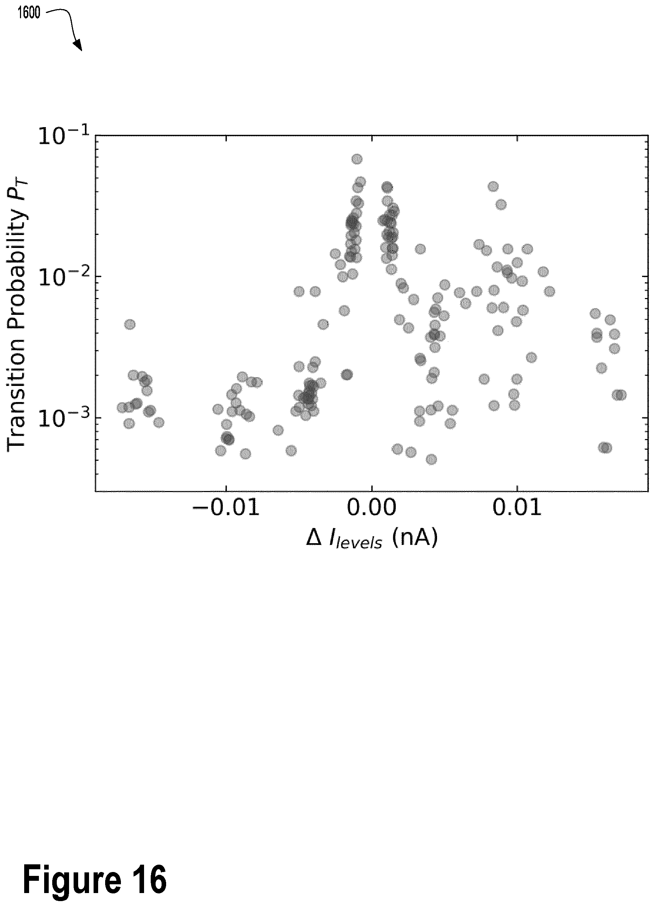

FIG. 16 illustrates a graph 1600 the top six transition probabilities versus change in current level, prior to normalization, in accordance with an example embodiment.

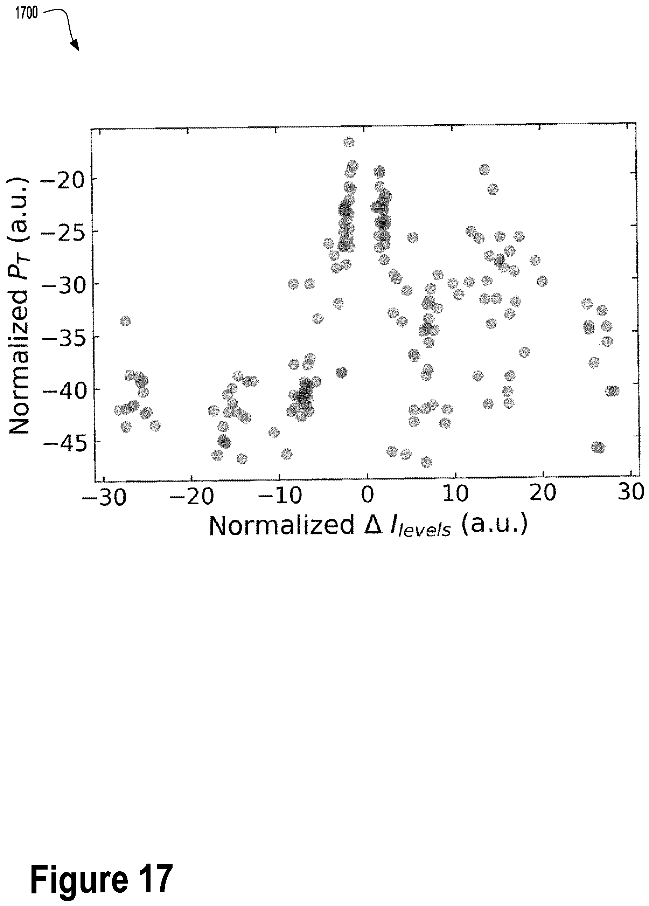

FIG. 17 illustrates a graph 1700 of the top six transition probabilities versus change in current level, in accordance with an example embodiment. Based on affinity propagation clustering model, the data points can be seen as "message passing" between each other. Furthermore, exemplar data points may be extracted i.e., cluster leaders chosen by all data points. Yet further, similarity between two points can be quantified by $-|\Delta I_i - \Delta I_j|^2$. Uneven cluster sizes are permissible and cluster leaders may correspond to input data points. In some embodiments, the clustering parameters (e.g., a preference parameter and a damping parameter) may be optimized.

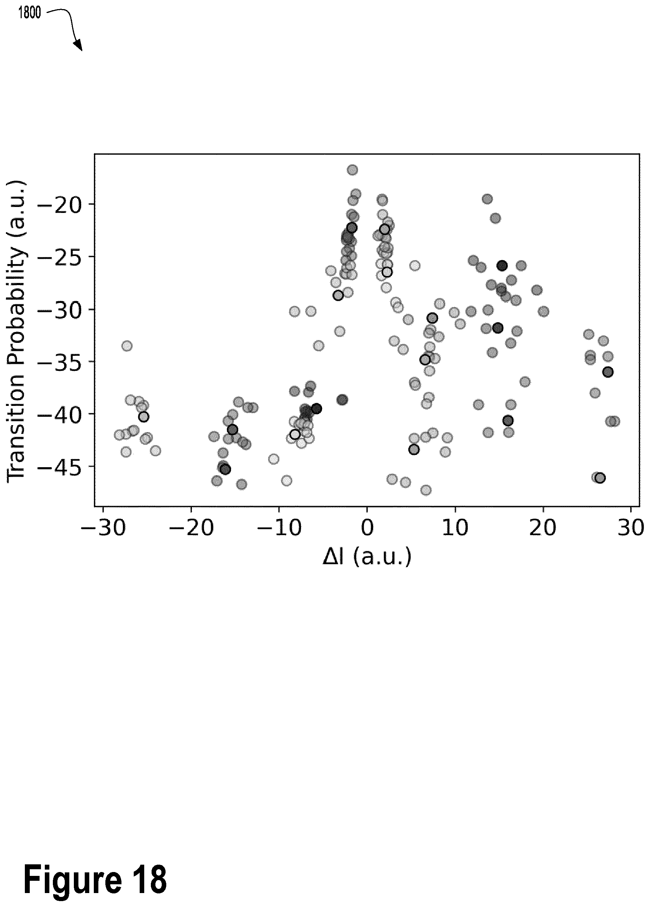

FIG. 18 illustrates a graph 1800 the top six transition probabilities after application of a clustering model, in accordance with an example embodiment.

Method 100 includes determining, using a maximum likelihood estimator 160, a base leakage value 162. In such scenarios, the maximum likelihood estimator 160 could be configured to fit a set of Gaussian peaks relating to the extracted discrete levels with a superposition of the filtered set of plausible level combinations. Accordingly, to find $I_{base}$, the 64 Linear Configurations $\{6\ I_{defects}\} + I_{base}$ should correspond to the Bayesian Current Levels $\{32\ I_{levels}\}$.

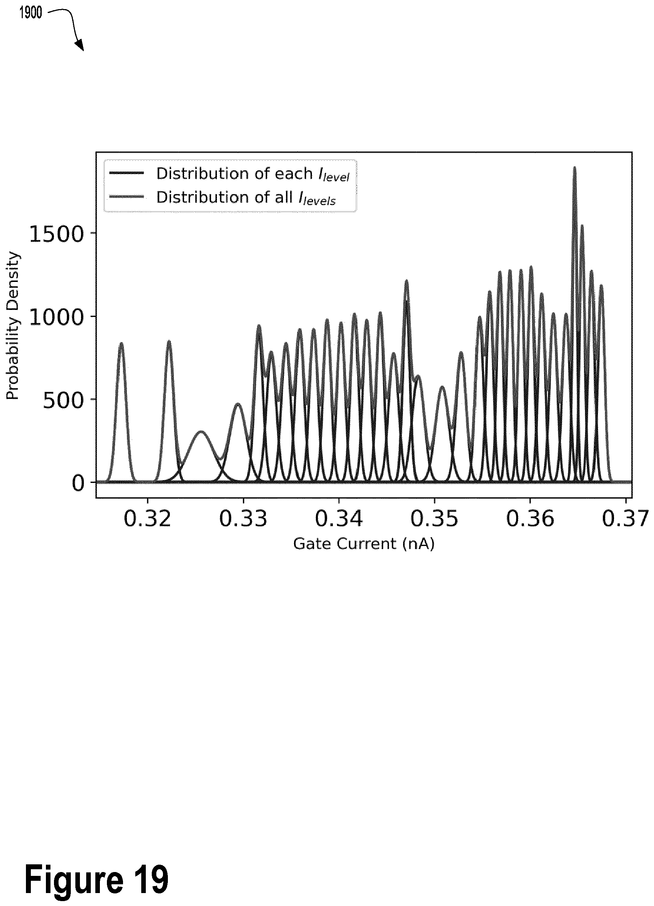

FIG. 19 illustrates a graph 1900 of a distribution of Bayesian-based levels and probability density function for individual discrete levels, in accordance with an example embodiment. As illustrated in graph 1900, the individual (unweighted) $I_{levels}$ PDFs are superimposed to provide a resultant distribution of $I_{levels}$.

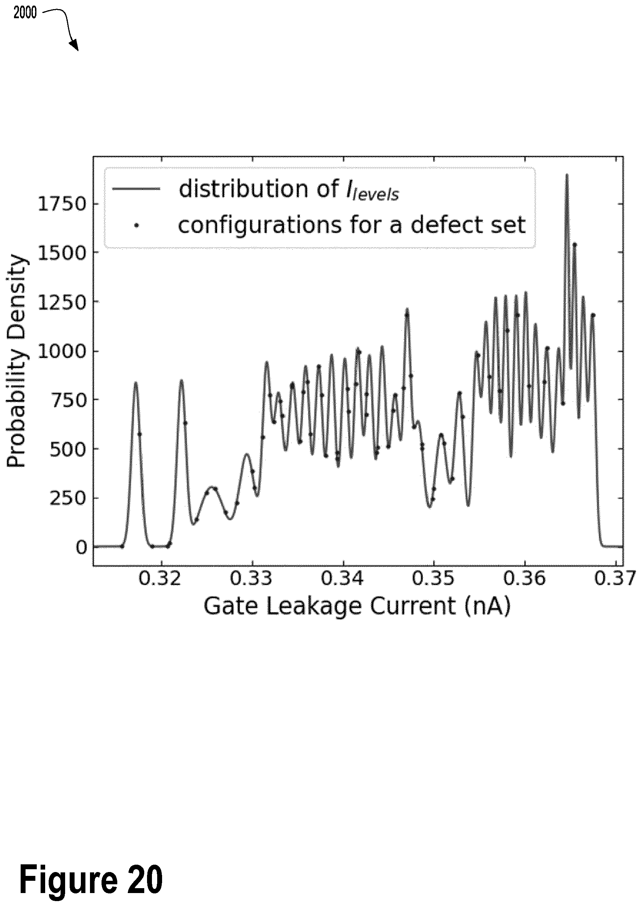

FIG. 20 illustrates a graph 2000 of a distribution of Bayesian-based levels and optimal current configurations, in accordance with an example embodiment.

$I_{base}$ range is assumed to be the extrema of $- I_{levels}$.

Interpolation of PDF values → 64 configurations $\{I_{defects}+I_{base}\}$

Furthermore, in some embodiments, a log likelihood estimator may be provided as $\sum_{i=1}^{c} \log(pdf_i)$. In such a scenario, maximizing the log likelihood estimator provides the optimal $I_{base}$.

Method 100 also includes a data reconstruction using defect currents 170. The data reconstruction includes determining, by mapping the extracted discrete levels to a linear superposition of each level of a set selected from the filtered set of plausible level combinations, a best fit data reconstruction of the measurement data and corresponding predicted levels.

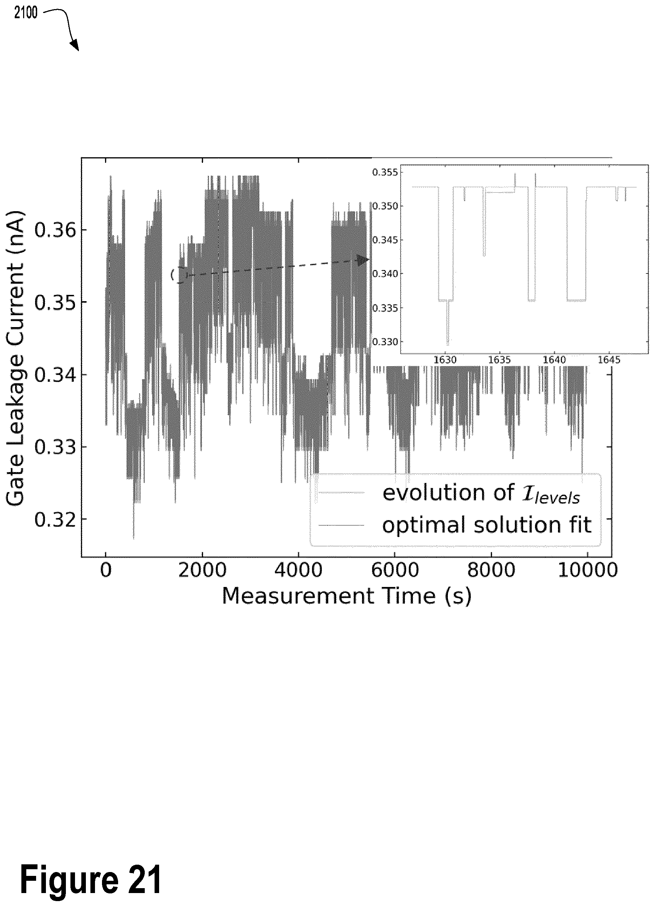

FIG. 21 illustrates an optimal solution and corresponding data reconstruction 2100, in accordance with an example embodiment.

In various examples, the optimal solution may include the optimal set of defects that can explain the observed data. In such scenarios, the optimal solution may be selected after data reconstruction through the definition of a cost function. In some embodiments, reconstructing the data includes, for each given extracted discrete level, determining whether a magnitude difference with respect to an adjacent predicted level is within a threshold deviation range of an independent probability density function (PDF) corresponding to the adjacent predicted level.

In such scenarios, if the magnitude difference with respect to the adjacent predicted level is greater than the threshold deviation range (e.g., three $\sigma$) of the independent PDF corresponding to the given predicted level, assigning a no-solution identifier to the adjacent predicted level. It will be understood that other threshold deviation ranges (e.g., two $\sigma$ or less; or greater than three $\sigma$) are possible and contemplated.

As an initial boundary condition, it is assumed that transitions involving simultaneous switching of multiple defects is improbable.

The data reconstruction includes:

- Initialize i = 1.
- For the quantized SILC Data (using Bayesian $I_{levels}$): find $\{I_{defects+base}\}$ configuration closest to $I_i$ and find $\{I_{defects+base}\}$ configuration closest to $I_{i+1}$.

    A) If transition from $\{I_{db}\}_i$ configuration is NOT mapped to $\{I_{db}\}_{i+1}$ configuration, then $BC_{violation}$ += 1.
    B) If transition from $\{I_{db}\}_i$ configuration is mapped to $\{I_{db}\}_{i+1}$ configuration, then $BC_{valid}$ +=1.
    C) If $\{I_{db}\}_i$ config. is NOT within $3\sigma$ range of $I_i$, then $BC_{no\text{-}solution}$ +=1.

Next, increment i and loop to find further configurations and evaluate A, B, and C above.

As an example, for a data set with 6 $I_{defects}$ (pA): {16.7, 15.5, 9.4, 5.0, 3.3, 2.0} and $I_{base}$ (pA): 315.7, the data reconstruction process may be performed to produce an optimal solution where valid transitions count = 24280, violations count = 1892, and no-solution count = 0. It will be understood that other optimal solutions (and respective valid transition count, violation count, and no-solution count) are possible and contemplated.

In various embodiments, method 100 also includes a deconvolution of the reconstructed data 180 so as to determine time constants 182 of individual defects 184.

Table 1 illustrates the equations utilized in the present method 100.

**Table 1:**

| 1 | $\sigma$ | Median $|I_{i+1} - I_1|$ |
|---|---|---|
| 2 | Transition Probability ($P_T$) | $\dfrac{\{I_x \to I_y\}}{\sum_{k=1}^{N} \{I_x \to I_k\}}$ |
| 3 | Error on $P_T(E_T)$ (Poisson process) | $\dfrac{\sqrt{\{I_x \to I_y\}}}{\sum_{k=1}^{N} \{I_x \to I_k\}}$ |
| 4 | Normalization of $P_T$ and $E_T$ | $log(E_T) = log(P_T + E_T) - log(P_T)$ <br> $Norm,\ log(P_T) = log(P_T)\ /\ median(log(E_T))$ <br> $Norm.\ log(E_T) = log(E_T)\ /\ median(log(E_T))$ |
| 5 | Error on $\Delta I$ ($\sigma_{\Delta I}$) | $\sqrt{\sigma_x^2 + \sigma_y^2}$ |
| 6 | Normalization of $\Delta I$ and $\sigma_{\Delta I}$ | $Norm.\ \Delta I = \Delta I\ /\ median(\sigma_{\Delta I})$ <br> $Norm.\ \sigma_{\Delta I} = \sigma_{\Delta I}\ /\ median(\sigma_{\Delta I})$ |
| 7 | Cost Function | $w_1 \dfrac{\sum_{k=1}^{N} \delta_k^{\,2}}{\sigma^2} + w_2 \dfrac{(\#multiple\ paths\ switching)}{(\#total\ transitions)}$ <br> $where\ \delta_k = I_{level} - I_{configuration}$ <br> $simplified\ (our)\ case:\ w_1 = \infty\ if\ any\ |\delta_k| > 3\sigma,\ and$ <br> $= 0\ otherwise$ |

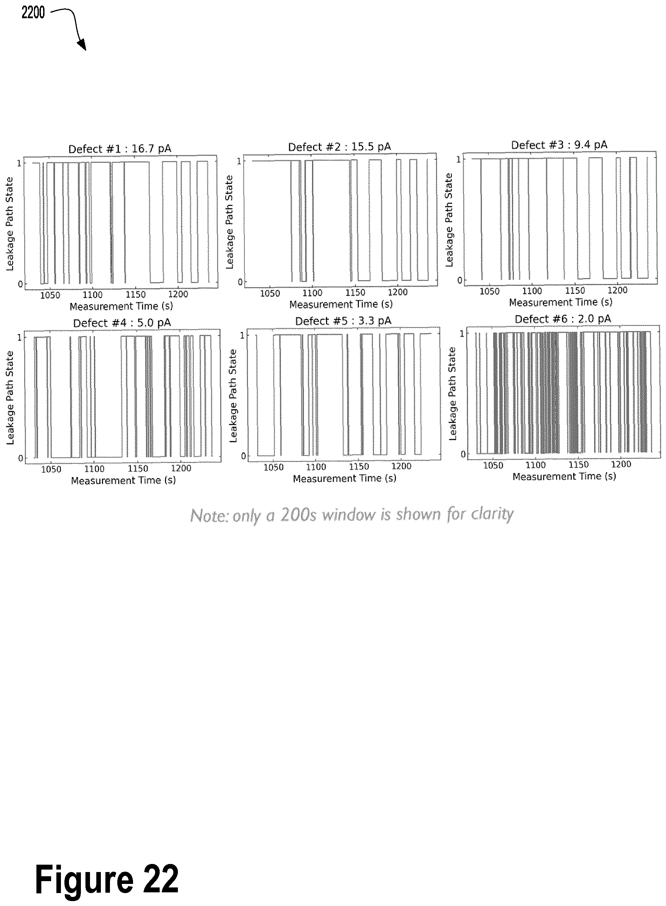

In order to find the optimal solution, each possible defect set is used to reconstruct the temporal evolution (transitions) of the discrete current levels. A 'cost' function is defined to keep track of the goodness of each solution (Table 1 eq. 7). This function considers two criteria: (1) all observed levels must be explained within preset error bars and (2) more than one instantaneous leakage path switch is punished. The reconstruction starts by finding the base (tunneling) leakage current ($I_{base}$) i.e., the current level if none of the defect paths are active. Note that this current level is not necessarily observed. $I_{base}$ is easily found by matching all configurations of a single defect set to the observed current levels using a maximum likelihood method, such as illustrated in FIG. 20. Finally, the cost function is calculated for each possible defect set and the set with minimal cost function is chosen as the optimal solution. In some examples, the optimal solution is a 6-defect set with the most accurate reconstruction shown in FIG. 21. This implies that only 32 out of 64 configurations are actually observed during the measurement time. FIG. 22 illustrates a deconvolution 2200 after finding an optimal solution, in accordance with an example embodiment. Furthermore, FIG. 22 shows the individual activity of each separate leakage path.

Based on the methods described herein, information about defects in gate oxide layers could be used for various applications including to predict, based on the best fit data reconstruction, an estimated time to failure (ETTF) of the semiconductor device. Additionally or alternatively, the applications could include mapping, based on the set of probable transitions, the set of probable defects in the gate dielectric layer of the semiconductor device or a defect density of the gate dielectric layer of the semiconductor device. It will be understood that other practical and useful applications of the disclosed methods are possible and contemplated.

### III. Enumerated Example Embodiments

The present disclosure is described in further detail in the following enumerated example embodiments (EEE). These embodiments are not intended to be limiting, and other embodiments may be possible.

EEE 1 is a method comprising:

receiving measurement data, wherein the measurement data is indicative of a random telegraph noise (RTN) signal;

extracting from the measurement data, using a Bayesian machine learning algorithm, a set of extracted discrete levels;

quantizing the measurement data by assigning each data point of the measurement data to a corresponding extracted discrete level;

determining, based on the quantized measurement data, a number of possible defect configurations;

applying a Markov Chain model to the extracted discrete levels to provide a state transition matrix, wherein the state transition matrix comprises, for each extracted discrete level, a transition probability of transitioning to a different extracted discrete level;

forming, based on a magnitude difference between respective discrete levels and the transition probabilities, a magnitude transition probability space;

applying a clustering model to the magnitude transition probability space to reduce a total number of plausible level combinations to a filtered set of plausible level combinations;

determining, using a maximum likelihood estimator, a base leakage value; and

determining, by mapping the extracted discrete levels to a linear superposition of each level of a set selected from the filtered set of plausible level combinations, a best fit data reconstruction of the measurement data and corresponding predicted levels.

EEE 2 is the method of EEE 1, wherein the measurement data comprises information indicative of a stress-induced leakage current (SILC) measurement.

EEE 3 is the method of EEE 1, wherein receiving measurement data comprises receiving electrical signals from a semiconductor device, wherein the semiconductor device comprises a high-k gate dielectric layer of a metal-oxide-semiconductor field-effect transistor (MOSFET), wherein at least a portion of the RTN signal is indicative of a time-dependent dielectric breakdown (TDDB) of the gate dielectric layer.

EEE 4 is the method of EEE 3, wherein the measurement data was obtained under normal operating conditions of the semiconductor device, wherein the normal operating conditions of the semiconductor device comprise a standard operating bias voltage as recommended by a manufacturer of the semiconductor device.

EEE 5 is the method of EEE 3, wherein the measurement data was not obtained under accelerated operating conditions of the semiconductor device, wherein accelerated operating conditions comprise an elevated bias voltage.

EEE 6 is the method of EEE 3, wherein the RTN signal is based on a presence of defects in a gate oxide of the semiconductor device.

EEE 7 is the method of EEE 1, wherein applying the Bayesian machine learning algorithm comprises initially determining an optimal noise level.

EEE 8 is the method of EEE 1, wherein applying the clustering model comprises initially normalizing the state transition matrix such that respective error bars for transition probability and level difference are similar.

EEE 9 is the method of EEE 1, wherein the clustering model comprises an affinity propagation algorithm.

EEE 10 is the method of EEE 1, wherein the maximum likelihood estimator is configured to fit a set of Gaussian peaks relating to the extracted discrete levels with a superposition of the filtered set of plausible level combinations.

EEE 11 is the method of EEE 1, further comprising:

for each given extracted discrete level, determining whether a magnitude difference with respect to an adjacent predicted level is within a threshold deviation range of an independent probability density function (PDF) corresponding to the adjacent predicted level.

EEE 12 is the method of EEE 11, wherein if the magnitude difference with respect to the adjacent predicted level is greater than the threshold deviation range of the independent PDF corresponding to the given predicted level, assigning a no-solution identifier to the adjacent predicted level.

EEE 13 is the method of EEE 11, wherein the threshold deviation range comprises three $\sigma$.

EEE 14 is the method of EEE 3, further comprising:

predicting, based on the best fit data reconstruction, an estimated time to failure (ETTF) of the semiconductor device.

EEE 15 is the method of EEE 3, further comprising:

mapping, based on the set of probable transitions, the set of probable defects in the gate dielectric layer of the semiconductor device or a defect density of the gate dielectric layer of the semiconductor device.

While some embodiments have been illustrated and described in detail in the appended drawings and the foregoing description, such illustration and description are to be considered illustrative and not restrictive. Other variations to the disclosed embodiments can be understood and effected in practicing the claims, from a study of the drawings, the disclosure, and the appended claims. The mere fact that certain measures or features are recited in mutually different dependent claims does not indicate that a combination of these measures or features cannot be used. Any reference signs in the claims should not be construed as limiting the scope.

**Claims**

1. A method comprising:

   receiving measurement data (110), wherein the measurement data is indicative of a random telegraph noise (RTN) signal;
   extracting from the measurement data, using a Bayesian machine learning algorithm (120), a set of extracted discrete levels (122);
   quantizing the measurement data by assigning each data point of the measurement data to a corresponding extracted discrete level (130);
   determining, based on the quantized measurement data, a number of possible defect configurations;
   applying a Markov Chain model to the extracted discrete levels (140) to provide a state transition matrix (142), wherein the state transition matrix comprises, for each extracted discrete level, a transition probability of transitioning to a different extracted discrete level;
   forming, based on a magnitude difference between respective discrete levels and the transition probabilities, a magnitude transition probability space;
   applying a clustering model (150) to the magnitude transition probability space to reduce a total number of plausible level combinations to a filtered set of plausible level combinations;
   determining, using a maximum likelihood estimator (160), a base leakage value; and
   determining, by mapping the extracted discrete levels to a linear superposition of each level of a set selected from the filtered set of plausible level combinations, a best fit data reconstruction of the measurement data and corresponding predicted levels.

2. The method according to claim 1, wherein the measurement data comprises information indicative of a stress-induced leakage current (SILC) measurement (112).

3. The method according to any of claims 1 or 2, wherein receiving measurement data (110) comprises receiving electrical signals from a semiconductor device, wherein the semiconductor device comprises a high-k gate dielectric layer of a metal-oxide-semiconductor field-effect transistor (MOSFET) (200, 202), wherein at least a portion of the RTN signal is indicative of a time-dependent dielectric breakdown (TDDB) of the gate dielectric layer.

4. The method according to claim 3, wherein the measurement data was obtained under normal operating conditions of the semiconductor device, wherein the normal operating conditions of the semiconductor device comprise a standard operating bias voltage as recommended by a manufacturer of the semiconductor device.

5. The method according to claim 3, wherein the measurement data was not obtained under accelerated operating conditions of the semiconductor device, wherein accelerated operating conditions comprise an elevated bias voltage.

6. The method according to any of claims 3 to 5, wherein the RTN signal is based on a presence of defects in a gate oxide of the semiconductor device.

7. The method according to any of the preceding claims, wherein applying the Bayesian machine learning algorithm (120) comprises initially determining an optimal noise level.

8. The method according to any of the preceding claims, wherein applying the clustering model (150) comprises initially normalizing the state transition matrix such that respective error bars for transition probability and level difference are similar.

9. The method according to any of the preceding claims, wherein the clustering model comprises an affinity propagation algorithm.

10. The method according to any of the preceding claims, wherein the maximum likelihood estimator (160) is configured to fit a set of Gaussian peaks relating to the extracted discrete levels with a superposition of the filtered set of plausible level combinations.

11. The method according to any of the preceding claims, further comprising:
   for each given extracted discrete level, determining whether a magnitude difference with respect to an adjacent predicted level is within a threshold deviation range of an independent probability density function (PDF) corresponding to the adjacent predicted level.

12. The method of claim 11, wherein if the magnitude difference with respect to the adjacent predicted level is greater than the threshold deviation range of the independent PDF corresponding to the given predicted level, assigning a no-solution identifier to the adjacent predicted level.

13. The method according to claims 11 or 12, wherein the threshold deviation range comprises three $\sigma$.

14. The method according to any of claims 3 to 5, further comprising:
    predicting, based on the best fit data reconstruction, an estimated time to failure (ETTF) of the semiconductor device.

15. The method according to claim 14, further comprising:
    mapping, based on the set of probable transitions, the set of probable defects in the gate dielectric layer of the semiconductor device or a defect density of the gate dielectric layer of the semiconductor device.

100

| Receiving Measurement Data 110 SILC Data 112 | → | Bayesian-inspired Algorithm 120 Distinct Current Levels 122 | → | Data Quantization 130 Noise Filtering 132 |

| Maximum Likelihood Estimator 160 Optimal Base Current 162 | ← | Clustering Model 150 Defect Currents 152 | ← | Markov Chain 140 State Transition Matrix 142 |

| Data Reconstruction using Defect Currents 170 | → | Deconvolution of Reconstructed Data 180 Time Constants 182 of Individual Defects 184 |

# Figure 1

200

202

TiN - 3nm

TiAl - 3nm

TiN - 1nm

HfO$_2$ - 1.8nm

SiO$_2$ ~ 0.7nm

Si

# Figure 2

Continuous increase + noise

300

$I_{g,leak}$

302

time

Smaller area
Thinner oxide
Lower stress

Discrete increase + RTN

310

$I_{g,leak}$

312

time

Figure 3

400

**Figure 4**

500

Figure 5

Figure 6

700

estimator to find a current value at
a distance Δ or more from μ

P(E|H) = probability to find $I_I$ in interval [μ+Δ,+∞] U [-∞, μ-Δ]
P = 1 - F(μ+Δ, μ, σ) or P = F(μ-Δ, μ, σ)
for $I_I$ = μ : P = 1
for $I_I$ very far from μ : P → 0

# Figure 7

Figure 8

900

#$I_{levels}$ = 32

**Figure 9**

Figure 10

Figure 11

Figure 12

Figure 13

Figure 14

Figure 15

Figure 16

1700

Figure 17

1800

Figure 18

1900

**Figure 19**

Figure 20

2100

**Figure 21**

Figure 22

Europäisches
Patentamt

European
Patent Office

Office européen
des brevets

# EUROPEAN SEARCH REPORT

Application Number

EP 23 20 7819

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | CN 105 787 473 A (UNIV BEIJING) 20 July 2016 (2016-07-20) * paragraphs [0001], [0003], [0004], [0074], [0107]; claim 1; figures 3-6 * | 1-15 | INV. G01R31/28 G01R31/26 H01L21/66 |
| A | HIROMITSU AWANO ET AL: "Multi-trap RTN parameter extraction based on Bayesian inference", QUALITY ELECTRONIC DESIGN (ISQED), 2013 14TH INTERNATIONAL SYMPOSIUM ON, IEEE, 4 March 2013 (2013-03-04), pages 597-602, XP032418475, DOI: 10.1109/ISQED.2013.6523672 ISBN: 978-1-4673-4951-2 * page 1 - page 6 * | 1-15 | |
| A | Mehedi Mehzabeen: "Characterisation and modelling of Random Telegraph Noise in nanometre devices", , 1 January 2022 (2022-01-01), pages 1-142, XP093142012, DOI: 10.24377/LJMU.t.00016472 Retrieved from the Internet: URL:https://researchonline.ljmu.ac.uk/id/eprint/16472/ [retrieved on 2024-03-15] * Pages 18, 21, 39, 46, 65, 69, 71 * | 1-15 | TECHNICAL FIELDS SEARCHED (IPC) G01R H01L |
| A | US 7 587 374 B1 (LYNCH ROBERT S [US] ET AL) 8 September 2009 (2009-09-08) * column 1, line 13 - line 35 * * column 3, line 15 - line 35 * * column 9, line 55 - column 10, line 4 * | 1-15 | |

-/--

The present search report has been drawn up for all claims

| Place of search | Date of completion of the search | Examiner |
|---|---|---|
| Munich | 20 March 2024 | Bilzer, Claus |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons
........................................................................
& : member of the same patent family, corresponding
document

EPO FORM 1503 03.82 (P04C01)

page 1 of 2

Europäisches Patentamt

European Patent Office

Office européen des brevets

# EUROPEAN SEARCH REPORT

Application Number

**EP 23 20 7819**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | Malcolm Aj: "Multi-level Random Telegraph Noise Analysis Using Machine Learning Techniques", , 21 September 2020 (2020-09-21), pages 1-106, XP093142793, Retrieved from the Internet: URL:https://uwspace.uwaterloo.ca/bitstream /handle/10012/16342/Malcolm_AJ.pdf?sequenc e=5&isAllowed=y [retrieved on 2024-03-19] * page 9 - page 20 * ----- | 1-15 | |

TECHNICAL FIELDS
SEARCHED      (IPC)

The present search report has been drawn up for all claims

| Place of search | Date of completion of the search | Examiner |
|---|---|---|
| Munich | 20 March 2024 | Bilzer, Claus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 2 of 2

## ANNEX TO THE EUROPEAN SEARCH REPORT
## ON EUROPEAN PATENT APPLICATION NO.

EP 23 20 7819

This annex lists the patent family members relating to the patent documents cited in the above-mentioned European search report.
The members are as contained in the European Patent Office EDP file on
The European Patent Office is in no way liable for these particulars which are merely given for the purpose of information.

20-03-2024

| Patent document cited in search report | | Publication date | Patent family member(s) | Publication date |
|---|---|---|---|---|
| CN 105787473 | A | 20-07-2016 | NONE | |
| US 7587374 | B1 | 08-09-2009 | NONE | |

EPO FORM P0459

For more details about this annex : see Official Journal of the European Patent Office, No. 12/82